**Europäisches Patentamt**

**European Patent Office**

**Office européen des brevets**

(11) Veröffentlichungsnummer: **0 357 876**

**A2**

# (12) EUROPÄISCHE PATENTANMELDUNG

(21) Anmeldenummer: **89108922.9**

(22) Anmeldetag: **18.05.89**

(51) Int. Cl.5: **H03J 7/02**

(30) Priorität: **05.09.88 DE 3830100**

(43) Veröffentlichungstag der Anmeldung:
**14.03.90 Patentblatt 90/11**

(84) Benannte Vertragsstaaten:
**CH DE FR GB LI**

(71) Anmelder: **AEG Olympia Aktiengesellschaft**
**Postfach 960**
**D-2940 Wilhelmshaven(DE)**

(72) Erfinder: **Jebe, Hans, Dipl.-Ing.**
**Brentanostrasse 55**
**D-1000 Berlin 41(DE)**
Erfinder: **Weber, Klaus, Dipl.-Ing.**
**Grüntaler Strasse 8**
**D-1000 Berlin 65(DE)**

(74) Vertreter: **Vogl, Leo, Dipl.-Ing.**
**AEG Olympia Aktiengesellschaft**
**Theodor-Stern-Kai 1**
**D-6000 Frankfurt 70(DE)**

(54) **Verfahren zur Optimierung der Abstimmung eines Senders und Anordnung zum Durchführen des Verfahrens.**

(57) Die Erfindung betrifft ein Verfahren zur Optimierung der Abstimmung eines mit einstellbaren Abstimmitteln versehenen Senders auf eine gewünschte Betriebsfrequenz, bei welchem Verfahren zunächst die Einstellung der Abstimmittel innerhalb eines Variationsbereichs durch Änderung der Einstellparameter variiert wird und während dieser Variation gleichzeitig der Wirkungsgrad und/oder die Verlustleistung des Senders bestimmt und zusammen mit den zugehörigen Einstellparametern abgespeichert wird sowie anschließend von diesen gespeicherten Einstellungen diejenige Einstellung, für die der höchste Wirkungsgrad bestimmt wurde, als Betriebseinstellung für den Betrieb des Senders auf der gewünschten Betriebsfrequenz ausgewählt und vorgenommen wird.

FIG 2

EP 0 357 876 A2

## Verfahren zur Optimierung der Abstimmung eines Senders und Anordnung zum Durchführen des Verfahrens

Die Erfindung betrifft ein Verfahren zur Optimierung der Abstimmung eines mit einstellbaren Abstimmitteln versehenen Senders auf eine gewünschte Betriebsfrequenz gemäß dem Oberbegriff des Patentanspruchs 1 sowie eine Anordnung zum Durchführen des Verfahrens. Ein solches Verfahren ist beispielsweise aus der EP-A2-O 239 219 bekannt.

Verfahren dieser Art werden z.B. bei der automatischen Abstimmung von Sendern, insbesondere von amplitudenmodulierten Hochleistungs-Rundfunksendern des Kurzwellenbereichs eingesetzt. Für einen solchen Sender sind i.a. mehrere vorgegebene Sende- oder Betriebsfrequenzen vorgesehen, zwischen denen der Sender in der Regel mehrmals am Tag hin- und hergeschaltet wird.

Für die Abstimmung eines solchen Senders werden i.a. für jede Betriebsfrequenz die Blindelemente der Abstimmkreise jeweils auf ihren zu dieser Frequenz gehörenden Kapazitäts-oder Induktivitätswert eingestellt. In der Regel werden diese Elemente so eingestellt, daß sie unabhängig von dem jeweiligen Betriebsfrequenzbereich etwa gleiche Impedanzen aufweisen. Allerdings treten i.a. Abweichungen von der Voreinstellung auf, wenn z.B. die Antenne eine Fehlanpassung aufweist oder die Betriebsfrequenz nicht genau mit derjenigen Frequenz, für die die Voreinstellung festgelegt wurde, übereinstimmt oder wenn eine Verstimmung der Abstimmkreise auftritt, die durch Erwärmung der Bauelemente bedingt ist.

Ein solcher Sender muß daher fortlaufend oder in regelmäßigen Abständen, zumindest jedoch beim Wechsel der Betriebsfrequenz erneut abgestimmt werden, um optimale Sendebedingungen erzielen zu können. Dies geschieht heutzutage in der Regel vollautomatisch.

Die bisher verwendeten Verfahren benutzen zur automatischen Abstimmung, ausgehend von dem zu der jeweiligen Betriebsfrequenz zugeordneten Voreinstellungswerten der Abstimmittel (Spulen und Kondensatoren) die Phasenbeziehungen und die Spannungsamplituden im Sender. Die hierzu notwendigen Meßwandler sind relativ aufwendig. Um parasitäre Einflüsse zu eliminieren bzw. zu vermindern, sind zur korrekten Erfassung von Spannung und Phase in der Regel zusätzliche und aufwendige Korrekturschaltungen erforderlich.

Lang- bzw. Mittelwellensender wurden bislang in der Regel nicht mit einer solchen Abstimmautomatik ausgestattet, auch ändert sich deren Betriebsfrequenz nur sehr selten. Dennoch ist auch in diesen Sendern der Einsatz der eingangs genannten Verfahren zur Optimierung der Abstimmung denkbar.

Bei dem aus der EP-A1-O 239 219 bekannten Verfahren wird auf die genaue Erfassung von Phasenbeziehungen und Spannungsamplituden verzichtet und statt dessen der Wirkungsgrad des Senders in Abhängigkeit von der Einstellung der Abstimmittel bestimmt.

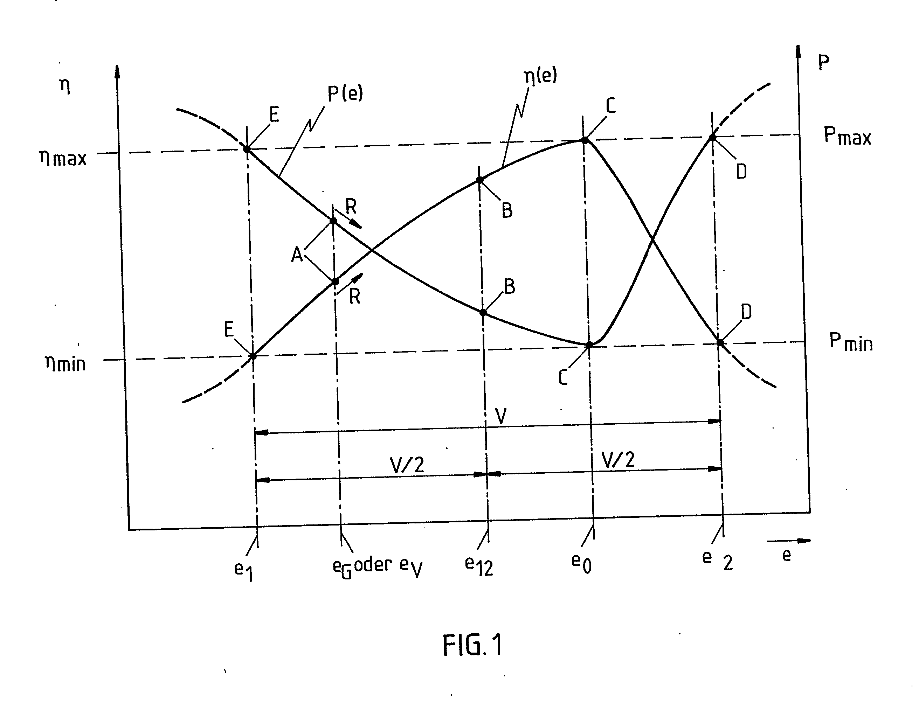

Hierzu werden, wie die FIG. 1 zeigt, ausgehend von einer der jeweiligen Betriebsfrequenz zugeordneten Voreinstellung $e_G$ der Abstimmittel, die Einstellparameter $e$ der Abstimmittel solange in eine Richtung geändert, bis der Wirkungsgrad $\eta$ des Senders bei einer bestimmten ersten Grenzeinstellung $e_1$ oder $e_2$ der Abstimmittel einen bestimmten, vorgegebenen Minimalwert $\eta$ min erreicht hat. Danach wird die Änderungsrichtung umgekehrt und die Einstellparameter $e$ wiederum innerhalb eines Variationsbereichs $V$ solange geändert, bis der Wirkungsgrad $\eta$ des Senders bei einer bestimmten zweiten Grenzeinstellung $e_2$ oder $e_1$ den gleichen vorgegebenen Minimalwert $\eta$ min erreicht. Danach wird diejenige Einstellung $e_{12}$ der Abstimmittel ermittelt, die genau in der Mitte zwischen den beiden Grenz-Einstellungen $e_1$ und $e_2$ liegt. Anschließend werden die Einstellparameter $e$ so geändert, daß die Abstimmittel diese Einstellung $e_{12}$ einnehmen, die dann die optimierte Betriebseinstellung des Senders ist.

Der Nachteil dieses Verfahrens besteht vor allem darin, daß, wie die FIG. 1 zeigt, die ermittelte Mitten-Einstellung $e_{12}$ nicht unbedingt identisch ist mit der optimalen Einstellung $e_o$, bei dem der Wirkungsgrad $\eta$ des Senders sein Maximum $\eta$ max annimmt.

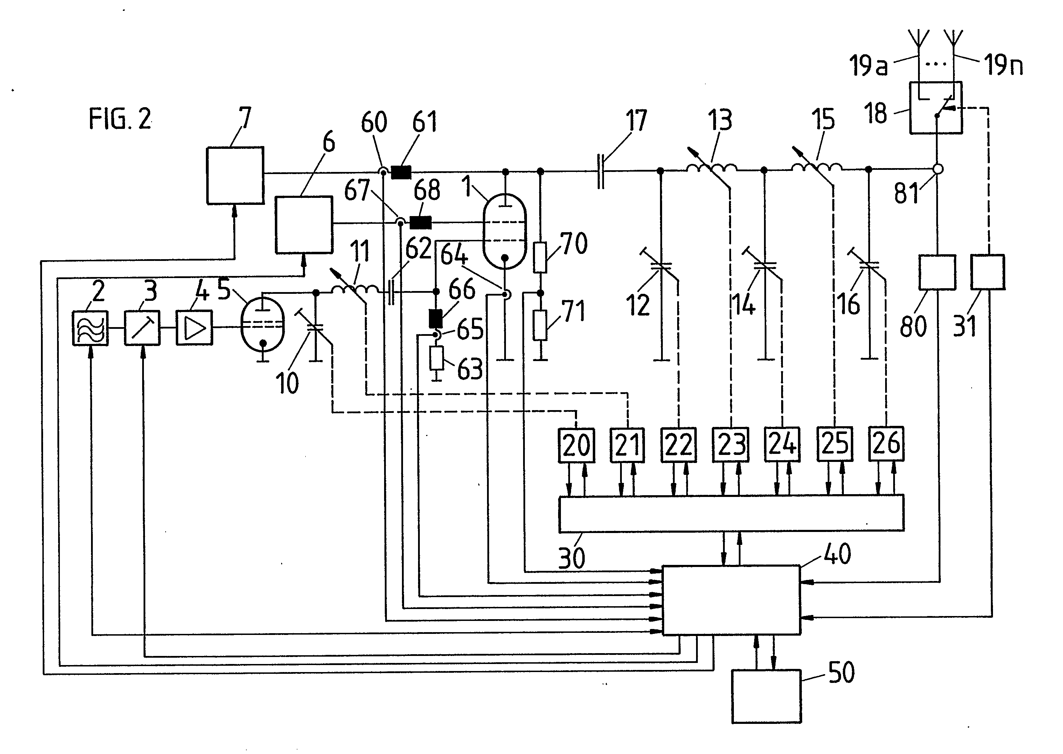

Ein weiterer Nachteil dieses Verfahrens besteht darin, daß i.a. ein Großteil des zu variierenden Bereichs $V$ der Wirkungsgrad-Kennlinie $\eta$ (e) zweimal durchlaufen und ausgewertet werden muß, was mit entsprechend hohem Zeit- und Rechenaufwand verbunden ist. Ist der Startpunkt des Verfahrens z.B. in Punkt A auf der Kennlinie $\eta$ (e) und ist die Variationsrichtung R zunächst in Richtung des Pfeils in FIG. 2 gewählt, wird bei dem bekannten Verfahren der Kennlinienteil ABCD bei der Abstimmung zweimal durchlaufen und zweimal ausgewertet. Lediglich der Kennlinienteil AE wird nach der Umkehrung der Variationsrichtung R nur einmal durchlaufen und ausgewertet.

Die Aufgabe der Erfindung besteht darin, ein Verfahren der eingangs genannten Art zu schaffen, bei dem die optimierte Betriebseinstellung möglichst mit der optimalen Betriebseinstellung übereinstimmt und bei dem diese Betriebseinstellung möglichst schnell ermittelt wird.

Die erfindungsgemäße Lösung dieser Aufgabe ist in dem Patentanspruch 1 beschrieben. Die übrigen Ansprüche enthalten vorteilhafte Aus- und Weiterbildungen des erfindungsgemäßen Verfahrens sowie Details einer vorteilhaften Anordnung zum Durchführen des erfindungsgemäßen Verfahrens und eine bevorzugte Anwendung der Erfindung.

Bei dem erfindungsgemäßen Verfahren erfolgt die Optimierung der Abstimmung, indem die Einstellung der Abstimmittel durch Änderung der Einstellparameter innerhalb eines Variationsbereichs variiert wird und gleichzeitig zu jeder Einstellung der Wirkungsgrad des Senders ermittelt und zusammen mit den zugehörigen Einstellparametern in einem Speicher abgespeichert wird. Anschließend wird aus der Reihe der gespeicherten Einstellungen diejenige Einstellung ($e_o$ in FIG. 1), für die der höchste Wirkungsgrad ermittelt wurde, als optimierte Betriebseinstellung ausgewählt und im Sender vorgenommen.

In einer bevorzugten Weiterbildung des Verfahrens wird vor dem Optimierungsprozeß eine für die Betriebsfrequenz geeignete voreinstellung ($e_V$ oder $e_G$ in FIG. 1) des Senders, insbesondere der Abstimmittel vorgenommen, die als Ausgangspunkt für die Variation der Einstellung e dient und die vorteilhaft aus einem früheren Optimierungsprozeß genommen wird ($e_V$) oder, wenn noch kein Optimierungsprozeß durchgeführt worden ist, aus den übrigen Betriebsparamtern des Senders und/oder der nachgeschalteten Antennenkonfiguration abgeleitet wird ($e_G$).

In einer weiteren vorteilhaften Weiterbildung des Verfahrens wird der Variationsbereich (V in FIG. 1) der Einstellungen e dadurch festgelegt, indem ein unterer Grenzwert ($\eta$ min in FIG. 1) für den Wirkungsgrad vorgegeben wird, bei dessen Erreichen bei einer ersten Grenz-Einstellung $e_1$ oder $e_2$ die Variation der Einstellung e in ihrer Richtung R umgekehrt bzw. - bei dessen erneutem Erreichen bei einer anderen Grenz-Einstellung $e_2$ oder $e_1$ -die Variation abgebrochen wird.

Zwar wird auch beim erfindungsgemäßen Verfahren u.U. der größte Teil des Kennlinienverlaufs zweimal durchfahren (beim Start in Punkt A in FIG. 1 der Teil $\overline{ABCD}$ ), jedoch wird jeder durchfahrene Kennlinienteil dieser Teil nur einmal ausgewertet und abgespeichert, so daß dieser Teil beim zweiten Durchgang schneller durchfahren werden kann. Dies ist insbesondere dann von Vorteil, wenn in dem zuerst durchfahrenen Kennlinienteil von der Starteinstellung bis zur ersten Grenz-Einstellung kein Wirkungsgradmaximum festgestellt werden konnte, da in diesem Fall die Abstimmelemente sehr schnell in ihre ursprüngliche Starteinstellung gebracht werden können, um von dort ausgehend in geänderter Richtung in ihrer Einstellung variiert zu werden, wobei erneut Meßwerte aufgenommen werden.

In bestimmten Anwendungen kann es vorteilhaft sein, die Optimierung iterativ durchzuführen und dabei die Startpunkte und die Schrittweiten der einzelnen Iterationszyklen in Abhängigkeit vom Ergebnis des jeweils vorangegangenen Iterationszyklusses festzulegen. Der Iterationsprozeß wird hierbei abgebrochen, wenn der im letzten Iterationszyklus bestimmte höchste Wirkungsgrad sich um weniger als einen vorgegebenen Betrag von dem höchsten Wirkungsgrad des jeweils vorangegangenen Iterationszyklusses unterscheidet oder mit diesem Wirkungsgrad übereinstimmt.

Mit dieser Abwandlung des Verfahrens können auf besonders ökonomischer Weise Sender abgestimmt werden, bei denen noch keine sinnvollen Voreinstellungen bekannt sind und bei denen die Einstellung e der Abstimmittel daher über einen großen Variationsbereich V variiert werden muß um die Kennlinie $\eta$ (e) erstmalig zu ermitteln. Vorzugsweise wird nun in einem solchen Fall zunächst in dem ersten Iterationszyklus die gesamte Wirkungsgradkennlinie mit einer relativ großen Schrittweite durchfahren. In dem zweiten und den nachfolgenden Iterationszyklen wird man systematisch solange den Variationsbereich V einengen (wobei das im jeweils vorangegangen Iterationszyklus gemessene Maximum des Wirkungsgrades in dem neuen (engeren) Variationsbereich enthalten sein muß) und die Schrittweite verkleinern, bis die optimale Einstellung erreicht bzw. nahezu erreicht ist.

In vielen anderen Fällen ist es nicht erforderlich, die optimale Einstellung zu erreichen bzw. ihr möglichst nahe zu kommen, sondern es reicht aus, eine bessere Abstimmung als die vorgegebene zu erreichen. Für diese Fälle kann das erfindungsgemäße Verfahren dahingehend abgewandelt werden, daß die Ermittlung des Wirkungsgrades in Abhängigkeit von der Einstellung der Abstimmittel dann abgebrochen wird, wenn ein relatives Wirkungsgradmaximum im jeweiligen Variationsbereich der Einstellungen erkennbar ist und der mit dieser Einstellung erreichbare Wirkungsgrad für den Anwendungszweck ausreichend ist.

Wird das Verfahren zur Optimierung eines mehrstufigen Senders verwendet, werden vorteilhaft die einzelnen Stufen getrennt voneinander und nacheinander optimiert.

Im folgenden wird die Erfindung anhand der Figuren näher erläutert. Es zeigen

FIG. 1 die bereits diskutierte Kennlinie des Wirkungsgrades $\eta$ bzw. der Verlustleistung P eines Senders in Abhängigkeit von der Einstellung e der Abstimmittel des Senders

FIG. 2 ein bevorzugtes Ausführungsbeispiel einer erfindungsgemäßen Anordnung zum Durchführen des erfindungsgemäßen Verfahrens in einem amplitudenmodulierten Sender mit anodenmodulierter Leistungstetrode in der RF-Endstufe des Senders.

Das in FIG. 1 gezeigte Beispiel einer Kennlinie $\overline{EABCD}$ des Wirkungsgrades $\lambda$ eines Senders in Abhängigkeit der Einstellung e der Abstimmittel des Senders bzw. der Sendereinstellung allgemein geht von dem Fall aus, daß die Kennlinie keinen symmetrischen Verlauf bezüglich ihres Maximums C aufweist. Zur Durchführung des erfindungsgemäßen Verfahrens wird eine bestimmte Voreinstellung der Abstimmittel bzw. des Senders vorgenommen, die aufgrund eines früheren Optimierungsprozesses gewonnen sein kann ($e_V$) oder eine aus den übrigen Betriebsparametern abgeleitete Grobeinstellung ($e_G$) sein kann. In dieser Einstellung hat der Sender den Wirkungsgrad bei Punkt A.

Es sei nun angenommen, daß die Einstellung e der Abstimmittel in Richtung R verändert wird, so daß der Wirkungsgrad $\eta$ des Senders zunächst sukzessive bis zum Maximalwert $\eta$ max im Punkt C anwächst und anschließend wieder abfällt, bis er im Punkt D bei der Grenz-Einstellung $e_2$ den vorgegebenen Minimalwert $\eta$ min erreicht, bei dem der Variationsprozeß in seiner Richtung umgekehrt wird und die Kennlinie solange in umgekehrter Richtung durchlaufen wird bis im Punkt E bei der anderen Grenz-Einstellung $e_1$ dieser Minimalwert $\eta$ min wieder erreicht wird. Hierbei werden die Messungen des Wirkungsgrades erst wieder nach Erreichen der Einstellung $e_V$ oder $e_G$ bei Punkt A der Kennlinie aufgenommen. Die Berechnung des Wirkungsgrades erfolgt hierbei für die einzelnen Punkte auf der Kennlinie jeweils nur einmal. Die Werte werden zusammen mit den zugehörigen Einstellparametern abgespeichert. Anschließend wird die Einstellung $e_o$, bei der der höchste Wirkungsgrad $\eta$ max gemessen worden ist, als Betriebseinstellung des Senders ausgewählt und der Sender entsprechend eingestellt.

FIG. 2 zeigt ein vorteilhaftes Ausführungsbeispiel einer erfindungsgemäßen Anordnung zum Durchführen des erfindungsgemäßen Verfahrens in einem amplitudenmodulierten Sender mit einer anodenmodulierten Leistungstetrode in der RF-Endstufe des Senders.

Die Anodenspannung der Leistungstetrode 1 wird von einem Hochleistungs-Modulationsverstärker 7 bereitgestellt, der in Form eines Pulsdauer-, Pulsfrequenz- oder Pulsstufenmodulationsverstärkers realisiert sein kann und daher auch Gleichspannung übertragen kann.

Die Schirmgitterspannung der Tetrode 1 wird von einem Netzgerät 6 geliefert. Die RF-Trägerfrequenz wird in einem RF-Generator oder Steuersender 2 erzeugt, in einem nachgeschalteten Pegelsteller 3 auf den vorgesehenen Eingangspegel eingestellt, anschließend in einem Verstärker 4 verstärkt und auf das Steuergitter einer Treiberröhre 5 gegeben. Die Anodenspannung der Treiberröhre 5 wird über einen Abstimmkreis 10 und 11 dem Steuergitter der Leistungstetrode 1 zugeführt. Die Tetrode 1 ist ausgangsseitig über einen Blockkondensator 17 mit dem Ausgangs-Abstimmkreisen 12-16 verbunden, an die eine Antennenkonfigurations-Wähleinrichtung 18 mit verschiedenen Antennenkonfigurationen 19a-19n angeschlossen ist.

Die Abstimmittel 10-16 der Abstimmkreise werden über Stellmotore 20-26 von einer Steuerungs/Überwachungseinrichtung 30 getrennt angesteuert und in ihrer Einstellung überwacht.

Anodenstrom, Schirmgitterstrom und Steuergitterstrom und der Leistungstetrode 1 werden über Stromwandlereinrichtungen 60-63, 65-68, die Anodenspannung der Röhre über einen Spannungsteiler 70, 71 gemessen. Der Kathodenstrom der Röhre wird bestimmt, in dem der hierzu proportionale Spannungsabfall an der Kathode am Meßpunkt 64 gemessen wird. Der Widerstand 63 dient dabei zur Gleichspannungser zeugung, der Kondensator 62 zum Abblocken dieser Gleichspannung. Die Ausgangsleistung des Senders wird mit einem Leistungsmesser 80 an einen Meßpunkt 81 am Ausgang der Abstimmkreise 12-16 ermittelt.

Eine Steuerungs/Überwachungseinrichtung 31 steuert und überwacht die Antennenkonfigurations-Wähleinrichtung 18.

Die Meßanordnungen 60-68, 70, 71 für Röhrenströme und Anodenspannung der Leistungstetrode 1 und die Steuerungs-und Überwachungseinrichtungen 30 bzw. 31 für die Abstimmittel 10-16 bzw. und für die Antennenkonfigurations-Wähleinrichtung 18 sind mit einem Rechner 40 verbunden, an dem außerdem noch ein Datenspeicher 50 angeschlossen ist. Ferner ist dieser Rechner 40 mit den Steuereingängen des Modulationsverstärkers 7, des Schirmgitternetzgerätes 6 und des Pegelstellers 3 sowie mit dem Steuereingang des Steuersenders 2 verbunden.

Die erstmalige Ermittlung einer Abstimmeinstellung erfolgt, nachdem die Abstimmittel 12-16 in der Endstufe grob voreingestellt sind. Hierzu entnimmt der Rechner 40 die Voreinstellwerte aus dem Datenspeicher 50 und nimmt die grobe Voreinstellung der Abstimmelemente 12-16 mit Hilfe der Antriebssteuerung 30 vor. Anschließend wird bei zunehmender Ansteuerung, die über den Rechner 40 und den Pegelsteller 3 durchgeführt wird, der Wirkungsgrad der Endstufenröhre 1 ermittelt.

Hierzu werden über die Stromwandlereinrichtung 60 und den Spannungsteiler 70, 71 der Anodenstrom und die Anodenspannung der RF-Endstufenröhre 1 gemessen und die Meßwerte dem Rechner 40 zugeführt. Wahlweise kann der Anodenstrom auch durch Bestimmung des Kathodenstromes durch Messung des Spannungsabfalls am Meßpunkt 64 und Subtraktion der Steuergitter- und Schirmgitterstromwerte vom Kathodenstromwert ermittelt werden. In dem Rechner 40 wird durch Multiplikation dieser Werte für Anodenspannung und Anodenstrom die aufgenommene Anodenleistung berechnet.

Der Meßwandler 80 am Ausgang des Senders liefert den Meßwert der Ausgangsleistung an den Rechner 40, der durch Division der Werte der Ausgangsleistung und der aufgenommenen Anodenleistung den Anodenwirkungsgrad und durch deren Subtraktion die Anodenverlustleistung der RF-Endstufenröhre 1 berechnet. Abweichend von bekannten Verfahren gemäß der EP-A2-0 239 219 erfolgt bei dem erfindungsgemäßen Verfahren die Optimierung der Abstimmung, nachdem die für die Betriebsfrequenz gültige Voreinstellung des Senders vorgenommen wurde, indem die Abstimmelemente 10-16 unter Beachtung der Grenzen für die zulässige Verlustleistung, der für den Frequenzbereich gültigen Schrittweite und der maximal zulässigen Abweichung von der Voreinstellung die für die Abstimmung notwendigen Elemente (z.B. 13 und 15) variiert werden und gleichzeitig die Wirkungsgradwerte für jede Sendereinstellung im Rechner 40 berechnet und im Datenspeicher 50 gespeichert werden. Nach der Ermittlung der möglichen Sendereinstellungen wird diejenige ausgewählt, die den höchsten Wirkungsgrad aufweist.

Die Ermittlung der Wirkungsgrade kann in vielen Fällen dann abgebrochen werden, wenn ein relatives Maximum des Wirkungsgrades im jeweiligen Abstimmbereich der Elemente deutlich erkennbar ist und die vorgegebenen Werte für die Ausgangsleistung und den minimal einzuhaltenden Wirkungsgrad dabei erreicht werden.

Die so gefundene Abstimmungseinstellung der Abstimmelemente wird nach erfolgter Abstimmung zusammen mit der jeweiligen Sendefrequenz, deren Wert dem Steuersender 2 entnommen wird, und der benutzten Antennkonfiguration 19a...19n, die der Antennenkonfigurations-Wähleinrichtungsüberwachung 31 entnommen wird, im Datenspeicher 50 gespeichert, damit sie für eine spätere Abstimmung auf derselben Frequenz dem System wieder zur Verfügung steht. Erfolgt bei der Ermittlung der Abstimmung eine Regelung der Anodenspannung in der Anodenspannungsversorgung 7 und/oder der Schirmgitterspannung im Netzgerät 6 und/oder eine Pegelanpassung in dem Pegelsteller 3, so werden diese Werte ebenfalls im Datenspeicher 50 gespeichert. Mit diesen Informationen ist es möglich, daß der Sender, sobald eine einmal betriebene Senderkonstellation (dieselbe Frequenz auf derselben Antennenkonfiguration) wieder betrieben wird, auf die früher ermittelten Abstimm-und Pegelwerte zurückgreifen kann. Durch dieses Zurückgreifen wird der Abstimmvorgang verkürzt, da eine erneute Ermittlung der Abstimmstellung entfällt.

Neben der Ermittlung der optimalen Einstellung der Abstimmittel 10-16 empfiehlt sich eine Anpassung der Ansteuerung und/oder der Elektrodenspannungen der Leistungstetrode 1, die durch die Größe der Ausgangsleistung bestimmt wird.

Es eignen sich beispielsweise zur Regelung der Ansteuerung ein elektronisch steuerbarer RF-Verstärker oder ein Dämpfungsglied und zur Einstellung der Elektrodenspannung ein elektronisch regelbares thyristorbestücktes Netzgerät 6 oder ein NF-Verstärker 7, der in der Lage ist, die Anodengleichspannung der Endstufenröhre 1 zu regeln, wie es z.B. bei einem Pulsdauer- oder Pulsstufenmodulationsverstärker der Fall ist. Diese Geräte erhalten die für den Abstimmvorgang und Sendebetrieb notwendigen Informationen aus dem Rechner 40. Diese rechnergesteuerte Überwachung ermöglicht es, daß auch bei nachlassender Emission der Röhren 1 und 5 die Senderleistung konstant gehalten wird.

Der Vorteil des erfindungsgemäßen Verfahrens bzw. der erfindungsgemäßen Anordnung besteht vor allem darin, daß der Sender tatsächlich optimal, d.h. unter Erzielung des größtmöglichen Wirkungsgrades, abgestimmt wird bzw. daß die Abstimmung zumindest nahezu optimal erfolgt und daß diese Abstimmung in einer vergleichsweise kurzen Abstimmzeit erreicht wird.

Es versteht sich, das das erfindungsgemäße Verfahren und die erfindungsgemäße Anordnung zum Durchführen des erfindungsgemäßen Verfahrens mit fachmännischen Können und Wissen auf vielerlei Art und Weise aus- und weitergebildet bzw. an die unterschiedlichen Anwendungen angepaßt werden können, ohne daß dies hier an dieser Stelle näher erläutert werden müßte.

So ist es z.B. denkbar, ein oder mehrere Sender an ein Datenübertragungsnetz wie z.B. das Datex-P-Netz anzuschließen und die erfindungsgemäße Optimierung der Abstimmung der einzelnen Sender von einer zentralen Steuerungs-und Überwachungsanordnung durchführen zu lassen, die ebenfalls an das Datenübertragungsnetz angeschlossen ist ("Automatische Fernsteuerung und Überwachung").

Weiterhin ist es denkbar, daß die Übertragung der Meß- und Steuersignale zum Teil oder gänzlich über Lichtleitkabel erfolgt und so eine hohe Störunempfindlichkeit der gesamten Abstimmanordnung erreicht wird.

Ferner ist es denkbar, die Störunempfindlichkeit der einzelnen Komponenten der Abstimmanordnung noch dadurch zu erhöhen, daß die Strommessungen mit magnetooptischen Meßwandlern nach dem Prinzip der Faraday-Rotation durchgeführt werden.

Schließlich ist es möglich, die Optimierung der Senderabstimmung auf der Basis der Sender-Verlustleistung P durchführen. Dies kann alternativ oder in Ergänzung zur Optimierung über den Sender-Wirkungsgrad erfolge. Der Verfahrensablauf ist in beiden Fällen gleich, wobei natürlich der Sender-Wirkungsgrad $\eta$ (e) auf ein Maximum einzustellen ist und die Sender-Verlustleitung P (e) auf ein Minimum (vgl. hierzu das Beispiel in FIG. 1).

Außerdem hierzu ist es möglich, die zum Betrieb der Signalelektronik benötigten Energie über eine Antenne dem Strahlungsfeld des Senders zu entnehmen.

**Ansprüche**

1. Verfahren zur Optimierung der Abstimmung eines mit einstellbaren Abstimmitteln versehenen Senders auf eine gewünschte Betriebsfrequenz, bei welchem Verfahren zunächst die Einstellung der Abstimmittel innerhalb eines Variationsbereichs durch Änderung der Einstellparameter bei gleichzeitiger Bestimmung des Wirkungsgrades und/oder der Verlustleistung des Senders variiert wird und anschließend eine dieser Einstellungen als Betriebseinstellung für den Betrieb des Senders auf der gewünschten Betriebsfrequenz ausgewählt wird, dadurch gekennzeichnet, daß die während der Variation der Einstellung (e) bestimmten Wirkungsgradwerte ( $\eta$ ) und/oder Verlustleistungswerte (P) zusammen mit den zugehörigen Einstellparametern abgespeichert werden und daß von den gespeicherten Einstellungen (e) die Einstellung, für die der höchste Wirkungsgrad ( $\eta$ max) und/oder der geringste Verlustleistungswert (Pmin) bestimmt wurde, anschließend als Betriebseinstellung (e$_o$) ausgewählt und vorgenommen wird.

2. Verfahren nach Anspruch 1, dadurch gekennzeichnet, daß als Ausgangspunkt für die Variation der Einstellung (e) eine aus einem früheren Optimierungsprozeß gewonnene Voreinstellung (e$_v$) oder, wenn ein solcher früherer Optimierungsprozeß noch nicht durchgeführt worden ist, eine aus den übrigen Betriebsparametern des Senders und/oder der nachgeschalteten Antennenkonfiguration abgeleitete Grobeinstellung (e$_G$) ausgewählt wird und daß der Variationsbereich (V) durch Vorgabe eines unteren Wirkungsgrad-Grenzwertes ($\eta$min) und/oder eines zulässigen oberen Verlustleistungswertes (Pmax) festgelegt wird.

3. Verfahren nach einem der Ansprüche 1 bis 2, dadurch gekennzeichnet, daß die Variation der Einstellung (e) in diskreten Schritten mit vorzugsweise konstanter Schrittweite durchgeführt wird.

4. Verfahren nach Anspruch 3, dadurch gekennzeichnet, daß die Variation iterativ durchgeführt wird, daß die Startpunkte und die Schrittweiten der einzelnen Iterationszyklen in Abhängigkeit vom Ergebnis des jeweils vorangegangenen Iterationszyklus festgelegt werden und daß der Iterationsprozeß abgebrochen wird, wenn der im jeweils letzten Iterationszyklus bestimmte höchste Wirkungsgrad bzw. geringste Verlustleistungswert um weniger als einen vorgegebenen Betrag von dem im jeweils vorangegangenen Iterationszyklus bestimmten höchsten Wirkungsgrad bzw. geringsten Verlustleistungswert abweicht oder gleich diesem Wirkungsgrad bzw. Verlustleistungswert ist.

5. Verfahren nach einem der Ansprüche 1 bis 4, dadurch gekennzeichnet, daß bei Sendern mit mehreren abzustimmenden Stufen die Abstimmung der einzelnen Stufen für jede Stufe getrennt optimiert wird und daß die einzelenen Optimierungsprozeße nacheinander durchgeführt werden.

6. Verfahren nach einem der Ansprüche 1 bis 5, dadurch gekennzeichnet, daß bei einem Sender mit einer RF-Endstufenröhre bzw. einer RF-Transistorendstufe zur Bestimmung des Wirkungsgrades der Anodenstrom und die Anodenspannung der Röhre bzw. der Kollektorstrom und die Kollektorspannung des Transistors (der Transistoren) gemessen werden und die daraus folgende Eingangsleistung mit der Ausgangsleistung des Senders verglichen wird.

7. Verfahren nach Anspruch 6, dadurch gekennzeichnet, daß bei einem Sender mit einer RF-Endstufenröhre der Anodenstrom entweder direkt oder durch Messung des Kathodenstroms und des Steuergitterstromes und, bei Verwendung einer Tetrode als RF-Endstufenröhre, des Schirmgitterstromes sowie durch anschließende Subtraktion des gemessenen Steuergitter- und gegebenenfalls Schirmgitterstromes von dem gemessenen Kathodenstrom gemessen wird.

8. Verfahren nach einem der Ansprüche 6 bis 7, dadurch gekennzeichnet, daß zusätzlich auch die an den Röhrenelektroden anliegenden Betriebsspannungen sowie der Eingangspegel des RF-Trägers in vergleichbarer Weise in den Optimierungsprozeß mit einbezogen und entsprechend angepaßt werden.

9. Verfahren nach einem der Ansprüche 1 bis 8, dadurch gekennzeichnet, daß am Ende des Optimierungsprozesses neben den optimierten Einstellparametern für die Abstimmittel zusätzlich die optimierten Werte der an den Röhrenelektroden anliegenden Betriebsspannungen und des Eingangspegels des RF-Trägers und/oder weitere relevante Betriebsparameter des Senders und/oder der nachgeschalteten Antennenkonfiguration abgespeichert werden und daß mit diesen Werten die Voreinstellung des Senders beim nächsten Optimierungsprozeß eingestellt wird.

10. Anordnung zum Durchführen des Verfahrens nach einem der Ansprüche 1 bis 9, dadurch gekennzeichnet,

- daß die Optimierung der Abstimmung des Senders über einen Rechner (40) erfolgt;

- daß der Rechner (40) mit einem Datenspeicher (50) zur Speicherung der für die Optimierung erforderlichen Daten und Werte und mit einer Steuerungs- und Überwachungseinrichtung (30) für die einstellbaren Abstimmittel (10-16) sowie mit Meßeinrichtungen (60, 61 bzw. 62-68; 70, 71, 80) zur Messung der für die Bestimmung der Wirkungsgradwerte erforderlichen Meßgrößen verbunden ist;

- daß der Rechner (40) vorzugsweise zusätzlich mit einer Steuerungs/Überwachungseinrichtung (31) für eine Antennenkonfigurations-Wähleinrichtung (18) verbunden ist,

- daß bei einem Sender mit anodenmodulierten RF-Endstufenröhre (1) und mit steuerbaren ersten Einrichtungen (6, 7) zur Einstellung der an den Röhrenelektroden anliegenden Betriebsspannungen sowie mit einer steuerbaren zweiten Einrichtung (3) zur Einstellung des Eingangspegels des RF-Trägers der Rechner (40) vorzugsweise zusätzlich mit den Steuereingängen der ersten Einrichtungen (6, 7) und der zweiten Einrichtung (3) verbunden ist,

- daß der Rechner (40) mit einem den RF-Träger erzeugenden steuerbaren Generator (2) verbunden ist zur Übermittlung der in dem Generator (2) einzustellenden RF-Trägerfrequenz.

11. Anordnung nach Anspruch 10, dadurch gekennzeichnet, daß die Steuerungs- und Überwachungseinrichtung (30) für die einstellbaren Abstimmittel (10-16) über separate Stellmotore (20-26) mit den Abstimmitteln (10-16) verbunden ist.

12. Anordnung nach Anspruch 10, dadurch gekennzeichnet, daß bei einem Sender mit anodenmodulierten RF-Endstufenröhre (1) die zur Bestimmung des Wirkungsgrades des Senders erforderliche Messung des Anodenspannung über einen Spannungsteiler (70, 71) und des Anodenstroms über eine Stromwandlereinrichtung (60) in der Anodenspannungszuführung oder über Stromwandlereinrichtungen (64, 65, 67) in der Kathoden-, der Steuergitter- und, bei Verwendung einer Tetrode als RF-Endstufenröhre (1), der Schirmgitterspannungszuführung erfolgt.

13. Anordnung nach einem der Ansprüche 10 bis 12, dadurch gekennzeichnet, daß die Übermittlung der Meß- und Steuersignale zum Teil oder gänzlich über Lichtleitkabel erfolgt.

14. Verfahren nach einem der Ansprüche 1 bis 9 bzw. Anordnung nach einem der Ansprüche 10 bis 13, gekennzeichnet durch die Anwendung in einem Hochleistungs- Rundfunksender des Lang-, Mittel- oder Kurzwellenbereichs mit einer anodenmodulierten RF-Endstufentetrode oder mit einer RF-Transistorendstufe.

FIG.1

FIG. 2